# FASCICULE DE BREVET EUROPEEN

(11) **EP 3 237 894 B1**
(45) Date de publication et mention de la délivrance du brevet: **12.02.2020**
(21) Numéro de dépôt: 15825860.8
(22) Date de dépôt: 23.12.2015
(51) Int. Cl.: G01N 25/72, H01L 21/66, H02S 50/10, H01L 51/00, H05K 1/00

(54) **PROCÉDÉ DE FABRICATION D'UN MODULE OPTOÉLECTRONIQUE AYANT UN SUPPORT COMPRENANT UN SUBSTRAT MÉTALLIQUE, UN REVÊTEMENT DIÉLECTRIQUE, ET UNE COUCHE CONDUCTRICE**
VERFAHREN ZUR HERSTELLUNG EINES OPTOELEKTRONISCHEN MODULS MIT EINEM TRÄGER MIT EINEM METALLSUBSTRAT, EINER DIELEKTRISCHEN SCHICHT UND EINER LEITFÄHIGEN SCHICHT
METHOD FOR THE PRODUCTION OF AN OPTOELECTRONIC MODULE INCLUDING A SUPPORT COMPRISING A METAL SUBSTRATE, A DIELECTRIC COATING AND A CONDUCTIVE LAYER

(30) Priorité: 24.12.2014 WO PCT/IB2014/067309
(43) Date de publication de la demande: 01.11.2017
(73) Titulaire: Arcelormittal, 1160 Luxembourg (LU)
(72) Inventeur: GUAINO, Philippe, 4000 Liège (BE)
(74) Mandataire: Lavoix
(86) Numéro de dépôt international: PCT/IB2015/059922
(87) Numéro de publication internationale: WO 2016/103206

(56) Documents cités:
- EP-A1- 2 320 473
- WO-A1-01/07901
- WO-A1-2011/135195
- WO-A1-2014/032781
- JP-A- 2014 107 053
- US-A1- 2010 062 550
- US-A1- 2010 210 040

## Description

La présente invention concerne un procédé de fabrication d'un module optoélectronique comportant un support comprenant un substrat métallique, un revêtement diélectrique, et une couche conductrice.

Un tel support est par exemple utilisé comme support d'alimentation pour des dispositifs optoélectroniques et convient particulièrement pour une intégration dans des dispositifs organiques ou inorganiques.

Les dispositifs optoélectroniques en question comportent des composants ajoutés sur le support, tels que, par exemple, des diodes électroluminescentes (LEDs), des diodes électroluminescentes organiques (OLEDs), des cellules photovoltaïques en couches minces ou non, des transistors pour écrans de visualisation tels que des écrans TFT (« thin-film transistor ») ou encore des capteurs photosensibles.

De tels supports sont par exemple décrits dans le document WO 2011/135195 de la demanderesse.

La qualité du support dépend notamment de l'intégrité du revêtement diélectrique. Pour tester cette intégrité, selon une première méthode exposée en page 11 du document précité, le support est testé dans un état intermédiaire de fabrication, dans lequel il ne comporte que le substrat métallique et le revêtement diélectrique. Des plots carrés conducteurs de taille prédéfinie sont déposés au laboratoire sur le revêtement diélectrique et une tension de dix volts est appliquée entre le substrat métallique et chaque plot. Puis, le courant de fuite est mesuré et l'isolation électrique au niveau du plot est jugée satisfaisante si le courant de fuite mesuré est inférieur à une certaine valeur en mA/cm². L'isolation électrique de l'ensemble est jugé satisfaisante lorsque tous les plots présentent un courant de fuite inférieur à cette valeur.

Toutefois, la méthode ne permet pas de contrôler en ligne le support comprenant le substrat métallique, le revêtement diélectrique, et la couche conductrice, en particulier lorsque cette dernière est continue sur l'ensemble du support. En outre, la méthode ne permet pas de tester le revêtement diélectrique situé entre les plots et au delà des plots. Enfin, elle ne permet pas de localiser les défauts situés sous un même plot, ni de les caractériser.

En page 12 du document précité, une autre méthode de contrôle consiste à appliquer une tension élevée au support et à vérifier s'il ne se produit pas un claquage du revêtement diélectrique en mesurant le courant de fuite. Si le courant de fuite reste inférieur à une certaine valeur, la tension de claquage du support est jugée suffisamment élevée.

Toutefois, la méthode ne permet pas de localiser, ni de caractériser les éventuels défauts du revêtement diélectrique ayant occasionné le claquage.

Par ailleurs, il est connu de contrôler le dispositif optoélectronique obtenu à partir du support. Toutefois, un tel contrôle intervient à un stade tardif de la fabrication du dispositif optoélectronique. Si le test révèle un défaut du dispositif optoélectronique, ce défaut peut concerner tout autant le support que des couches ou des composants déposés ultérieurement sur le support. En tout état de cause, le défaut est découvert à un stade tardif de la fabrication. Ceci entraînera des surcoûts.

Selon son abrégé, JP-A-2014107053 décrit un substrat pour un dispositif flexible, présentant une bonne résistance à l'humidité et une bonne adhérence d'une couche isolante.

Selon son abrégé, WO-A-01/07901 décrit une caméra thermographique infrarouge utilisée pour détecter des non-uniformités dans la température de surface d'une composition conductrice multicouche comprenant au moins deux couches électroconductrices (séparées par une couche isolante électronique.

Selon son abrégé, WO-A-2014/032781 décrit un procédé pour localiser au moins un défaut dans une structure comprenant une couche isolante.

Un but de l'invention est donc de fournir un procédé de fabrication d'un module optoélectronique comportant un contrôle du support constitué d'un ensemble comprenant successivement le substrat métallique, le revêtement diélectrique, et la couche conductrice, alors que l'ensemble est dépourvu de propriétés optoélectroniques, le contrôle permettant de localiser des défauts éventuellement présents dans le revêtement diélectrique, et au moins dans une certaine mesure de les caractériser.

A cet effet l'invention a pour objet un procédé selon la revendication 1.

Selon des modes particuliers de réalisation, le procédé de fabrication comprend l'une ou plusieurs des caractéristiques correspondant aux revendications 2 à 14, prise(s) isolément ou selon toutes les combinaisons techniquement possibles.

L'invention sera mieux comprise à la lecture de la description qui va suivre, donnée uniquement à titre d'exemple et faite en se référant aux dessins annexés sur lesquels :
- la figure 1 représente schématiquement une installation adaptée pour la mise en oeuvre des étapes de fourniture du support, d'excitation électrique du support, et d'examen photothermique du support excité d'un procédé selon l'invention,
- la figure 2 est une représentation schématique d'une image du support excité, l'image étant obtenue à l'aide de l'installation représentée sur la figure 1, et
- la figure 3 représente schématiquement un module optoélectronique obtenu par un procédé de fabrication selon l'invention, à partir du support représenté sur la figure 1.

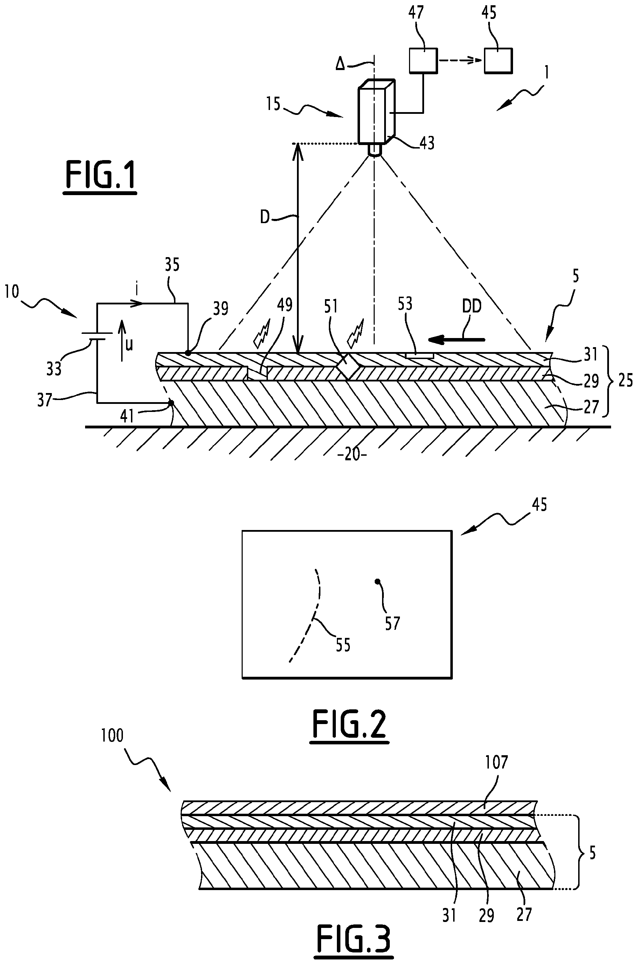

En référence à la figure 1, on décrit une installation 1 comportant un support 5, un dispositif 10 d'excitation électrique du support 5, et un système 15 d'examen photothermique du support 5 excité par le dispositif 10.

Le support 5 est constitué d'un ensemble 25 dépourvu de propriétés optoélectroniques.

Par « dépourvu de propriétés optoélectroniques », on entend que l'ensemble 25 ne comprend pas de composant optoélectronique, autrement dit pas de composant électronique qui émette ou interagisse avec la lumière, tel que, par exemple, des diodes électroluminescentes (LEDs), des diodes électroluminescentes organiques (OLEDs), des cellules photovoltaïques en couches minces ou non, des transistors pour écrans de visualisation ou encore des capteurs photosensibles.

Dans l'exemple représenté sur la figure 1, l'ensemble 25 comprend successivement un substrat métallique 27, un revêtement diélectrique 29 situé sur le substrat métallique 27, et une couche 31 électriquement conductrice située sur le revêtement diélectrique 29.

Par « couche électriquement conductrice », on entend une couche présentant une résistivité électrique inférieure ou égale à 10⁻³ ohm.m à température ambiante (20°C).

Selon des variantes non représentées, l'ensemble 25 comprend d'autres éléments, tout en restant dépourvu de propriétés optoélectroniques.

Le substrat métallique 27 est par exemple un corps plein de forme plate, c'est-à-dire de faible épaisseur comparée à ses autres dimensions. Le substrat peut se présenter sous la forme d'une plaque ou d'une feuille constituée d'un matériau métallique unique ou d'un assemblage composite. Le substrat métallique 27 est par exemple une superposition de plusieurs couches du même matériau ou de matériaux différents, dont l'un au moins est un matériau métallique, cette superposition pouvant être réalisée par collage, par soudage, par galvanisation à chaud, par électrogalvanisation, par dépôt sous vide.

De préférence, le matériau métallique est un alliage métallique tel que l'acier. En fonction de l'application et des performances requises, on pourra avoir recours sans que cette liste soit exhaustive à de l'acier non revêtu, à de l'acier galvanisé, à des aciers recouverts d'un alliage de zinc comprenant 5% en poids d'Aluminium (Galfan®), à des aciers recouverts d'un alliage de zinc comprenant 55% en poids d'Aluminium, environ 1,5% en poids de Silicium, le reste étant constitué de zinc et d'impuretés inévitables dues à l'élaboration (Aluzinc®, Galvalume®), à des aciers recouverts d'un alliage d'Aluminium comprenant de 8 à 1 1 % en poids de Silicium et de 2 à 4% en poids de fer, le reste étant constitué d'aluminium et d'impuretés inévitables dues à l'élaboration (Alusi®), à des aciers recouverts d'une couche d'Aluminium (Alupur®), à des aciers inoxydables.

De préférence encore, le matériau métallique est une tôle métallique, autrement dit un produit plat obtenu par laminage de brames. Dans le cas d'une tôle d'acier, on pourra avoir recours aux produits de la liste ci-dessus. Une telle tôle métallique présente une épaisseur généralement comprise entre 0,1 mm et 3,0 mm, de préférence entre 0,3 et 1,5 mm. Une telle tôle présente les avantages d'être apte à être mise en forme, notamment par profilage, et d'être apte à résister à des charges importantes, notamment en tant que panneau de toiture.

Le revêtement diélectrique 29 a pour fonction de permettre d'isoler électriquement le substrat métallique pour éviter tout passage de courant entre la couche conductrice et le substrat.

Ce revêtement diélectrique 29 peut également avoir pour fonction de permettre de compenser la rugosité du substrat métallique et d'offrir une surface régulière pour le dépôt de la couche conductrice supérieure.

Par ailleurs, le revêtement diélectrique 29 peut également avoir pour fonction de constituer une barrière de protection du dispositif électronique vis-à-vis de particules et d'éléments diffusants depuis le substrat métallique ainsi qu'une barrière de protection du substrat métallique vis-à-vis des contaminations extérieures, qu'il s'agisse de vapeur d'eau ou d'oxygène susceptibles d'oxyder ou de corroder le substrat métallique.

Le revêtement diélectrique 29 peut être formé de couches organiques et/ou inorganiques.

Une couche diélectrique inorganique peut comprendre un matériau choisi parmi les céramiques telles que, par exemple la cordiérite, la forstérite ou la stéatite ou parmi les oxydes métalliques non conducteurs tels que, par exemple, TiO₂, Al₂O₃, SiO₂, éventuellement dopés par du bore ou du phosphore. Cette couche diélectrique inorganique peut être appliquée au moins partiellement sur le substrat, éventuellement revêtu, au moyen de toute méthode connue de dépôt de couches minces sous vide.

Une couche diélectrique organique peut comprendre par exemple un matériau polymère choisi parmi les polymères thermoplastiques ou les polymères thermodurcissables, les élastomères, les polyimides, les époxy, les polyoléfines, les polyamides, les matériaux cellulosiques, les matériaux styréniques, les matériaux polyacryliques, tels que le polyméthacrylate de méthyle, les polyéthers, les polyesters saturés, les matériaux vinyliques, tels que le polyacétate de vinyle, les matériaux polysulfoniques, les polymères fluorés, les laques hybrides organo-inorganiques basées sur la technologie sol-gel. Cette couche diélectrique organique peut être appliquée au moins partiellement sur le substrat, éventuellement revêtu, au moyen d'une méthode connue de dépôt de couches minces.

Le revêtement diélectrique de lissage peut être avantageusement formé par dépôt alterné d'un nombre quelconque de couches diélectrique organiques et de couches diélectriques inorganiques.

Selon le nombre de couches diélectriques, le revêtement diélectrique de lissage peut présenter une épaisseur variant entre 500 nm et 50 µm.

De préférence, le revêtement diélectrique 29 possède une permittivité relative supérieure ou égale à 2. Selon des modes particuliers de réalisation, la permittivité relative est supérieure à 5, 10, 100, voire supérieure à 1000.

La couche 31 électriquement conductrice a pour fonction première de permettre l'alimentation électrique des dispositifs électroniques destinés à être placés en contact avec tout ou partie de cette couche.

A cet effet, la couche 31 présente une résistance par carré de moins de 10 Ω, de préférence de moins de 5 Ω ou de moins de 1 Ω ; plus préférentiellement, elle présente une résistance par carré d'au plus 0,1 Ω. De façon classique, on entend par valeur de résistance par carré, la valeur de la résistance entre deux côtés opposés d'un carré imaginaire formé sur la surface de la couche dont on mesure la résistance.

La couche 31 comprend par exemple un ou plusieurs métaux ou alliages métalliques et/ou un ou plusieurs oxydes, nitrures ou carbures métalliques naturellement conducteurs ou rendus conducteurs par ajouts d'éléments conducteurs tels que le graphite, par exemple. Elle peut comprendre, par exemple, un élément choisi parmi le groupe constitué de Ag, Al, Au, Mo, Na et Cr, ces éléments étant habituellement utilisés en tant qu'électrode dans les dispositifs optoélectroniques. Elle peut être elle-même constituée de plusieurs sous-couches. Elle peut être appliquée au moyen d'une méthode de dépôt de couches minces sous vide.

Toutefois, ces matériaux ne sont pas forcément les meilleurs candidats pour augmenter le rendement thermoélectrique (variation de la température en fonction du courant qui traverse le défaut). En effet, tous ces matériaux ne présentent pas des coefficients à température (TCR) positifs et élevés et ne sont pas de bons matériaux à effet thermoélectrique.

On définit un bon matériau thermoélectrique à l'aide de son coefficient Seebeck (en V.K⁻¹), sa résistivité électrique ρ (en ohm.cm), sa conductivité thermique (en W.m⁻¹.K⁻¹). On trouve de bons matériaux thermoélectriques parmi les alliages inter métalliques, par exemple CeCu₆, CeSn₃, les alliages SiGe, les semi-conducteurs de type Bi₂Te₃, PbTe, GeTe, les alliages MgSiSn, les oxydes ZnO, TiO₂..., et dans des composés dérivés.

Avantageusement, la couche 31 est en matériau à coefficient de température positif (PTC). De tels matériaux ont la capacité de présenter une dépendance positive (augmentation de la température) forte de leur résistivité avec la température. Les métaux comme Pt, RhFe, ainsi que les semi-conducteurs tels que les oxydes de vanadium, le silicium amorphe, et les oxydes de fer sont de bons exemples de matériaux à coefficient de température positif.

L'épaisseur de la couche conductrice 31 se situe de préférence dans la gamme 10 nm - 5 µm pour permettre d'acheminer une puissance électrique suffisante en fonction du dispositif électronique considéré. Outre le fait d'offrir une haute conductivité au substrat revêtu, la couche conductrice, lorsqu'elle n'est pas transparente, peut permettre d'atteindre de hautes valeurs de réflectivité d'au moins 90 %, de préférence d'au moins 92 ou 95%, plus préférentiellement d'au moins 96 ou 97 %. Cette propriété est particulièrement intéressante lorsque le support est utilisé pour alimenter un dispositif comportant une source de lumière telle qu'une diode électroluminescente, car elle permet d'optimiser le rendement énergétique du dispositif électronique.

De préférence, la couche 31 électriquement conductrice recouvre sensiblement intégralement le revêtement diélectrique 29. Par là, on entend que la couche 31 a été déposée de sorte à recouvrir en continu le revêtement diélectrique 29, mais qu'elle a pu être structurée pour préparer l'intégration à venir des couches optoélectroniques. Cette structuration peut avoir été faite lors du dépôt de la couche 31, par exemple au moyen d'un jeu de masques (pochoirs), ou postérieurement au dépôt, par exemple par ablation laser.

En variante, afin d'augmenter l'émissivité du matériau, on recouvre la couche conductrice 31 d'un revêtement noir, de forte émissivité de surface, par exemple supérieure à 0,97, afin d'améliorer la mesure du contraste en température.

Le dispositif 10 d'excitation électrique comprend une source de tension 33, un premier circuit 35 destiné à connecter électriquement la couche 31 et la source de tension 33, et un deuxième circuit 37 destiné à connecter électriquement le substrat métallique 27 et la source de tension 33.

Le premier circuit 35 et le deuxième circuit 37 comprennent à leur extrémité opposée à la source de tension 33 respectivement des connecteurs 39, 41 destinés à être mis en contact électrique avec respectivement la couche 31 et le substrat métallique 27.

Les connecteurs 39, 41 sont avantageusement adaptés pour glisser respectivement sur la couche 31 et le substrat métallique 27 lorsque le support 5 défile par rapport au système 15 d'examen photothermique.

La source de tension 33 est avantageusement adaptée pour faire circuler un courant continu i à travers le support 5. Par exemple, la source de tension 33 délivre une tension continue comprise entre 10 mV et 100 V, de préférence comprise entre 1 et 20 V.

Le système 15 d'examen photothermique comprend une caméra 43 adaptée pour produire au moins une image 45 (figure 2) d'une portion du support 5 vu du côté de la couche 31 électriquement conductrice. Le système 15 comprend avantageusement des moyens informatiques 47 propres à générer l'image 45. Avantageusement, les moyens 47 sont également adaptés pour réaliser des calculs à partir de données contenues dans l'image 45.

Le système 15 d'examen photothermique est positionné sensiblement à l'aplomb de la zone du support 5 mise en contact électrique avec la source de tension 33.

La caméra 43 est par exemple sensible à la lumière infrarouge entre 1,5 µm et 14 µm. La caméra 43 possède par exemple un axe optique Δ sensiblement perpendiculaire au support 5. La caméra 43 est par exemple une caméra CCD.

La caméra 43 est avantageusement placée à une distance D du support 5 selon l'axe Δ comprise entre 1 et 100 mm selon le choix avantageux du système optique de focalisation. La caméra 43 est avantageusement configurée pour produire une image 45 dont la résolution est inférieure ou égale à 5 µm/pixel, de préférence inférieure ou égale à 15 µm/pixel, 30 µm/pixel.

La résolution spatiale augmente lorsque la distance D diminue.

Optionnellement, l'installation 1 comprend un système de défilement 20 adapté pour faire défiler le support 5 par rapport au système 15 d'examen photothermique. Ce système de défilement peut correspondre au système d'entraînement préexistant sur la ligne et/ou comporter des éléments supplémentaires, tels qu'une table d'inspection, un rail de translation de la caméra, par exemple dans une direction perpendiculaire au sens de défilement du support.

Le système de défilement 20 est adapté pour faire défiler le support 5 selon une direction DD. La direction DD est avantageusement sensiblement perpendiculaire à l'axe optique Δ.

Le système de défilement 20 est adapté pour dévider le support 5.

En référence aux figures 1 et 2, on va maintenant décrire le fonctionnement de l'installation 1 et un procédé selon l'invention.

Le procédé comprend au moins une étape de fourniture du support 5, une étape d'excitation électrique du support fourni, et une étape d'examen photothermique du support excité pour détecter d'éventuels défauts 49, 51 d'isolation du revêtement diélectrique 29, situés au moins en partie dans le revêtement diélectrique 29 et fournir un résultat d'examen photothermique.

L'étape de fourniture du support 5 peut comprendre l'approvisionnement d'un support 5 préalablement fabriqué. Dans ce cas, le support peut être fourni sous forme de bobine, être déroulé en entrée de l'installation 1, défiler dans l'installation au moyen du système de défilement, puis être rembobiné en sortie de l'installation 1.

Alternativement, le support 5 peut être au moins partiellement fabriqué au cours de la première étape du procédé selon l'invention. Dans ce cas, l'étape de fourniture du support 5 peut comprendre une sous-étape de dépôt de la couche électriquement conductrice 31 sur au moins une partie du revêtement diélectrique 29, éventuellement précédée d'une sous-étape de dépôt du revêtement diélectrique 29 sur le substrat métallique 27.

Avantageusement, la sous-étape de dépôt de la couche électriquement conductrice 31 est réalisée par un dépôt physique en phase vapeur, tel que, par exemple, la pulvérisation magnétron, l'évaporation sous vide, l'évaporation par faisceau d'électron en phase vapeur. Dans ce cas, le substrat métallique 27 peut être fourni sous forme de bobine, être déroulé en entrée d'une ligne de dépôt physique en phase vapeur, défiler dans la ligne, puis défiler dans l'installation 1 au moyen du système de défilement puis être rembobiné en sortie de l'installation 1.

Cette alternative présente l'avantage de permettre le dépôt de la couche électriquement conductrice dans tous les pores du revêtement diélectrique, que ces pores soient de taille micrométrique ou nanométrique. En conséquence, la détection des défauts est effectuée avec un très haut niveau de résolution, niveau que ne confèrent pas les autres techniques de dépôt de couche.

Cette alternative présente aussi l'avantage d'intégrer toutes les étapes sur une même ligne de production, tant les étapes de fabrication des couches successives que les étapes de contrôle.

Le support 5 ainsi fabriqué est par exemple sous une forme enroulée.

Le système de défilement 20 dévide le support 5. Puis le support 5 défile selon la direction DD.

L'étape d'excitation électrique se fait par une mise en contact électrique du substrat métallique 27 et de la couche 31 avec la source de tension 33. En pratique, les connecteurs 39, 41 sont mis en contact électrique avec respectivement la couche 31 et le substrat métallique 27.

La source de tension 33 délivre une tension U avantageusement comprise entre 10mV et 100 V, de préférence comprise entre 1 et 20V. L'homme du métier saura ajuster la tension U en fonction des circonstances et en particulier en fonction du matériau utilisé pour l'électrode, de l'épaisseur des couches, de la taille des défauts, etc., de sorte à éviter la dégradation de l'ensemble 25.

L'étape d'excitation électrique a une durée par exemple comprise entre 0,01 et 10 secondes.

En cas de présence des défauts 49, 51, le courant i circule dans le support 5 en se concentrant sur les défauts 49, 51. En effet, le reste du revêtement diélectrique 29 se comporte comme un isolant électrique. Il se produit un échauffement localisé au niveau des défauts 49, 51. La couche 31 présente une température de surface plus élevée au niveau des défauts 49, 51.

La détection et l'analyse des échauffements de température permettent ainsi de repérer et de discriminer les défauts.

Selon des modes de réalisations particuliers, au moins trois modes de mesure peuvent être envisagés : un mode continu, un mode pulsé et un mode AC (courant alternatif) en détection synchrone.

Dans le mode continu, une source de tension continue (DC) est appliquée pour faire circuler le courant continu, déterminé par la résistance du défaut mesuré. On mesure la variation de température ΔT. L'étape d'excitation électrique et l'étape d'examen photothermique sont alors concomitantes.

Dans le mode pulsé, on applique une impulsion de tension pendant un temps court déterminé. On mesure la variation de température ΔT après le passage d'un pic de courant à travers le défaut. L'étape d'examen photothermique est alors successive à l'étape d'excitation électrique.

Dans le mode AC en détection synchrone, une faible variation alternative de la tension est appliquée autour d'un signal de tension continue déterminé. A l'aide d'une détection synchrone, on mesure la variation de température alternative ΔT du signal émis, et le décalage de phase par rapport au signal d'entrée.

En pratique, la mesure de la variation de température ΔT est assurée par le système 15 d'examen photothermique.

A l'étape d'examen photothermique, au moins une image 45 du support 5 excité est prise dans le domaine infrarouge par la caméra 43. La température de surface plus élevée au niveau des défauts 49, 51 est ainsi détectée.

Les moyens informatiques 47 réalisent un calcul pour obtenir par exemple un gradient thermique en surface du support 5 excité, ou une grandeur représentative de ce gradient. Les moyens 47 permettent de révéler les endroits 55, 57 de l'image 45 (figure 2) où se situent les défauts 49, 54. Par exemple, les endroits 55, 57 sont matérialisés par des extrema de la grandeur représentative.

Dans l'exemple représenté, le défaut 49 est une rayure du revêtement diélectrique 29 matérialisée par une longue trace sur l'image 45 représentée sur la figure 2. Le défaut 51 est une simple inclusion qui se traduit par un point sur l'image 45. Il est donc possible, au moins dans une certaine mesure, de discriminer les défauts 49, 51.

Un défaut 53 de la couche 31 électriquement conductrice ne se traduit par aucun échauffement et n'apparaît pas sur l'image 45.

Selon une variante, la grandeur représentative est la température, et un extrémum de la température est recherché pour révéler les défauts 49, 51.

Selon une variante non représentée, deux images du support 5 excité sont prises, les deux images étant décalées temporellement et/ou spectralement l'une par rapport à l'autre.

Dans le cas de deux images décalées temporellement, il peut par exemple s'agir de la même portion du support 5 excité selon le mode pulsé, photographiée lors de deux pulsations successives. L'analyse de ces images successives permet d'affiner la détection et la caractérisation des défauts. Il peut également s'agir de deux images de deux portions adjacentes du support excité prises alors que le support est en défilement. Les moyens informatiques 47 permettent de juxtaposer les images de sorte à réaliser une cartographie du support.

Dans le cas de deux images décalées spectralement, il peut par exemple s'agir de la même portion du support excité photographiée dans le domaine visible d'une part et dans le domaine infrarouge d'autre part. Il est alors possible de faire apparaître les défauts détectés par analyse de l'image infrarouge sur l'image réalisée dans le domaine visible. Il est ainsi possible d'établir une cartographie des défauts du support 5.

Sur le même principe, et selon une autre variante non représentée, une pluralité d'images du support 5 excité est prise, les images étant décalées temporellement et/ou spectralement les unes par rapport aux autres.

L'étape d'examen photothermique fournit un résultat d'examen photothermique qui est par exemple l'image 45.

En variante, le résultat d'examen photothermique est une donnée selon laquelle la portion du support 5 correspondant à l'image 45 ne présente pas de défauts considérés comme gênants.

A l'issue du procédé de contrôle du support 5, le support 5 jugé non satisfaisant, ou bien seulement la portion correspondant à l'image 45, peut être rebuté.

Le support 5 et le résultat d'examen photothermique obtenu par le procédé précité forment un ensemble dans lequel le résultat d'examen photothermique constitue avantageusement un certificat du support 5.

En référence à la figure 3, on décrit un module optoélectronique 100 qui est par exemple une cellule photovoltaïque.

Par « cellule photovoltaïque », on entend par exemple un composant électronique qui, exposé à la lumière, produit de l'électricité grâce à l'effet photovoltaïque.

Le module optoélectronique 100 comprend un support 5 analogue au support décrit ci-dessus, et une couche supplémentaire 107 déposée sur la couche 31 électriquement conductrice du support 5.

La couche supplémentaire 107 présente des propriétés électroniques au sens défini ci-dessus.

Le module optoélectronique 100 présente des propriétés photovoltaïques dont le support 5 considéré seul est dépourvu.

Pour fabriquer le module optoélectronique 100, un procédé de contrôle tel que décrit ci-dessus est mis en œuvre pour tester le support 5.

Si le support 5 est jugé satisfaisant en fonction du résultat d'examen photothermique, la couche supplémentaire 107 est déposée sur la couche 31 pour obtenir le module optoélectronique 100.

Selon une variante du procédé de fabrication, le procédé de contrôle a déjà été mis en œuvre lorsque le support 5 est fourni pour la fabrication du module optoélectronique 100. Le support 5 utilisé est alors un support déjà contrôlé, par exemple sur un autre site de production. Le support 5 est alors avantageusement associé à un certificat établissant que le résultat d'examen photothermique est correct.

Grâce aux caractéristiques décrites ci-dessus, le procédé de contrôle du support 5 permet de localiser des défauts 49, 51 éventuels situés au moins en partie dans le revêtement diélectrique 29, alors que le support 5 est dépourvu de propriétés optoélectroniques. En outre, le résultat d'examen photothermique permet, au moins dans une certaine mesure, de discriminer entre des défauts tels que, par exemple le défaut ponctuel 51, ou la rayure profonde 49 du revêtement diélectrique 29.

Bien que l'invention ait été décrite pour du contrôle en ligne, il va de soi que l'invention peut tout aussi bien être mise en œuvre lors de contrôles qualité hors ligne, et donc sans défilement relatif du support par rapport au système d'examen photothermique.

## Revendications

1. Procédé de fabrication d'un module optoélectronique (100) comprenant un support (5) et une couche supplémentaire (107) située sur le support (5), le support (5) étant constitué d'un ensemble (25) dépourvu de propriétés optoélectroniques, l'ensemble (25) comprenant successivement un substrat métallique (27), un revêtement diélectrique (29) situé sur le substrat métallique (27), et une couche (31) électriquement conductrice située sur le revêtement diélectrique (29),
le procédé de fabrication comportant au moins, dans cet ordre :
- une étape de fourniture du support (5), par exemple en défilement, et de mise en œuvre d'un procédé de contrôle du support (5), ou une étape de fourniture du support (5), le support (5) ayant été soumis au procédé de contrôle, et
- une étape de dépôt d'au moins la couche supplémentaire (107) sur la couche (31) électriquement conductrice du support (5) pour obtenir le module optoélectronique (100),
le procédé de contrôle du support (5) comportant au moins les étapes suivantes :
- excitation électrique du support (5) par une mise en contact électrique du substrat métallique (27) et de la couche (31) électriquement conductrice avec une source de tension (33), et
- examen photothermique du support (5) excité pour détecter un éventuel défaut (49, 51) situé au moins partiellement dans le revêtement diélectrique (29) et fournir un résultat d'examen photothermique.

2. Procédé de fabrication selon la revendication 1, dans lequel le revêtement diélectrique (29) possède une permittivité relative supérieure ou égale à 2.

3. Procédé de fabrication selon la revendication 1 ou 2, dans lequel la couche (31) électriquement conductrice recouvre sensiblement intégralement le revêtement diélectrique (29).

4. Procédé de fabrication selon l'une quelconque des revendications 1 à 3, dans lequel la fourniture du support (5) comprend une sous-étape de dépôt de la couche (31) électriquement conductrice sur au moins une partie du revêtement diélectrique (29).

5. Procédé de fabrication selon la revendication 4, dans lequel la sous-étape de dépôt de la couche (31) électriquement conductrice comprend un dépôt physique en phase vapeur de la couche (31) électriquement conductrice sur le revêtement diélectrique (29).

6. Procédé de fabrication selon l'une quelconque des revendications 1 à 5, dans lequel la couche (31) électriquement conductrice a une épaisseur comprise entre 10 nanomètres et 5 µm.

7. Procédé de fabrication selon l'une quelconque des revendications 1 à 6, dans lequel l'étape d'excitation électrique a une durée comprise entre 0,01 et 10 secondes.

8. Procédé de fabrication selon l'une quelconque des revendications 1 à 7, dans lequel, à l'étape d'excitation électrique, la source de tension (33) est adaptée pour faire circuler un courant continu i à travers le support (5).

9. Procédé de fabrication selon l'une quelconque des revendications 1 à 8, dans lequel l'étape d'examen photothermique comprend la prise, dans le domaine infrarouge, d'au moins une image (45) du support (5) excité.

10. Procédé de fabrication selon la revendication 9, dans lequel l'étape d'examen photothermique comprend la prise de deux images décalées temporellement et/ou spectralement l'une par rapport à l'autre, ou de plus de deux images décalées temporellement et/ou spectralement les unes par rapport aux autres.

11. Procédé de fabrication selon l'une quelconque des revendications 9 et 10 dans lequel l'examen photothermique du support comprend la mesure de la variation de température du support (5) excité, la détection d'un éventuel défaut (49, 51) étant réalisée de préférence par la détermination d'un extremum d'une grandeur représentative d'un gradient thermique observé dans l'image (45).

12. Procédé de fabrication selon l'une quelconque des revendications précédentes, dans lequel la couche (31) est constituée par un quelconque ou plusieurs matériaux quelconques pris parmi : Al, Ag, Au, Mo, Na, Cr, CeCu₆, CeSn₃, les alliages SiGe, Bi₂Te₃, PbTe, GeTe, les alliages MgSiSn, ZnO, TiO₂, Pt, RhFe, les oxydes de vanadium, le silicium amorphe, et les oxydes de fer.

13. Procédé de fabrication selon l'une quelconque des revendications 1 à 12, dans lequel le module optoélectronique (100) est une cellule photovoltaïque.

14. Procédé de fabrication selon l'une quelconque des revendications 1 à 13, dans lequel la couche supplémentaire (107) possède des propriétés optoélectroniques.

## Patentansprüche

1. Verfahren zum Herstellen eines Optoelektronikmoduls (100), das einen Träger (5) und eine Zusatzschicht (107), die auf dem Träger (5) angeordnet ist, aufweist, wobei der Träger (5) aus einer Einheit (25) ohne optoelektronische Eigenschaften zusammengesetzt ist, wobei die Einheit (25) aufeinanderfolgend aufweist ein Metallsubstrat (27), eine dielektrische Beschichtung (29), die auf dem Metallsubstrat (27) angeordnet ist, und eine elektrisch-leitfähige Schicht (31), die auf der dielektrischen Beschichtung (29) angeordnet ist,
wobei das Herstellungsverfahren wenigstens, in dieser Reihenfolge, aufweist:
- einen Schritt des Bereitstellens des Trägers (5), z.B. beweglich, und des Realisierens eines Verfahrens zum Steuern des Trägers (5), oder einen Schritt des Bereitstellens des Trägers (5), wobei der Träger (5) dem Steuerverfahren unterworfen wird und
- einen Schritt des Deponierens von wenigstens einer Zusatzschicht (107) auf der elektrisch-leitfähigen Schicht (31) des Trägers (5), um das Optoelektronikmodul (100) zu erlangen,
wobei das Verfahren zum Steuern des Trägers (5) wenigstens die folgenden Schritte aufweist:
- elektrisches Anregen des Trägers (5) durch ein elektrisches In-Kontakt-Bringen des metallischen Substrats (27) und der elektrisch-leitfähigen Schicht (31) mit einer Spannungsquelle (33) und
- photothermisches Prüfen des Trägers (5), welcher zum Detektieren eines eventuellen Defekts (49, 51) angeregt wird, der wenigstens teilweise in der dielektrischen Beschichtung (29) angeordnet ist, und Bereitstellen eines Ergebnisses des photothermischen Prüfens.

2. Herstellungsverfahren gemäß Anspruch 1, wobei die dielektrische Beschichtung (29) eine relative Permittivität größer oder gleich 2 hat.

3. Herstellungsverfahren gemäß Anspruch 1 oder 2, wobei die elektrisch-leitfähige Schicht (31) die dielektrische Beschichtung (29) im Wesentlichen vollständig abdeckt.

4. Herstellungsverfahren gemäß irgendeinem der Ansprüche 1 bis 3, bei dem das Bereitstellen des Trägers (5) einen Unterschritt des Deponierens der elektrisch-leitfähigen Schicht (31) auf wenigstens einem Teil der dielektrischen Beschichtung (29) aufweist.

5. Herstellungsverfahren gemäß Anspruch 4, bei dem der Unterschritt des Deponierens der elektrisch-leitfähigen Schicht (31) eine physikalische Dampfabscheidung der elektrisch-leitfähigen Schicht (31) auf die dielektrische Beschichtung (29) aufweist.

6. Herstellungsverfahren gemäß irgendeinem der Ansprüche 1 bis 5, bei dem die elektrisch-leitfähige Schicht (31) eine Dicke zwischen 10 und 5 µm hat.

7. Herstellungsverfahren gemäß irgendeinem der Ansprüche 1 bis 6, bei dem der Schritt des elektrischen Anregens eine Dauer zwischen 0,01 und 10 Sekunden hat.

8. Herstellungsverfahren gemäß irgendeinem der Ansprüche 1 bis 7, bei dem im Schritt des elektrischen Anregens die Spannungsquelle (33) angepasst ist, um einen Gleichstrom i durch den Träger (5) fließen zu lassen.

9. Herstellungsverfahren gemäß irgendeinem der Ansprüche 1 bis 8, bei dem der Schritt des photothermischen Prüfens das Aufnehmen wenigstens eines Bilds (45) des angeregten Trägers (5) im Infrarotbereich aufweist.

10. Herstellungsverfahren gemäß Anspruch 9, bei dem der Schritt des photothermischen Prüfens das Aufnehmen von zwei zeitlich und/oder spektral voneinander versetzten Bildern oder von mehr als zwei zeitlich und/oder spektral voneinander versetzten Bildern aufweist.

11. Herstellungsverfahren gemäß irgendeinem der Ansprüche 9 und 10, bei dem das photothermische Prüfen des Trägers das Messen der Temperaturveränderung des angeregten Trägers (5) aufweist, wobei das Detektieren eines eventuellen Defekts (49, 51) vorzugsweise mittels Ermittelns eines Extremums einer repräsentativen Größe eines im Bild (45) beobachteten thermischen Gradienten realisiert wird.

12. Herstellungsverfahren gemäß irgendeinem der vorangegangenen Ansprüche, bei dem die Schicht (31) aus irgendeinem oder mehreren Materialien ausgewählt aus Al, Ag, Au, Mo, Na, Cr, CeCu₆, CeSn₃, SiGe-Legierungen, Bi₂Te₃, PbTe, GeTe, MgSiSn-Legierungen, ZnO, TiO₂, Pt, RhFe, Vanadiumoxiden, amorphem Silicium und Eisenoxiden zusammengesetzt ist.

13. Herstellungsverfahren gemäß irgendeinem der Ansprüche 1 bis 12, bei dem das Optoelektronikmodul (100) eine Photovoltaikzelle ist.

14. Herstellungsverfahren gemäß irgendeinem der Ansprüche 1 bis 13, bei dem die Zusatzschicht (107) optoelektronische Eigenschaften hat.

## Claims

1. A method for manufacturing an optoelectronic module (100) comprising a support (5) and an additional layer (107) located on the support (5), the support (5) consisting of an assembly (25) without any optoelectronic properties, the assembly (25) successively comprising a metal substrate (27), a dielectric coating (29) located on the metal substrate (27), and an electrically conductive layer (31) located on the dielectric coating (29),
the manufacturing method including at least, in this order:
- a step for providing the support (5), the support for example being running, and for applying a method for controlling the support (5), or a step for providing the support (5), the support (5) having been subject to the control method, and
- a step for depositing at least the additional layer (107) on the electrically conductive layer (31) of the support (5) for obtaining the optoelectronic module (100),
the control method for the support (5) including at least the following steps:
- an electric excitation of the support (5) by putting into electric contact the metal substrate (27) and the electrically conductive layer (31) with a voltage source (33), and
- a photothermal examination of the excited support (5) for detecting a possible defect (49, 51) located at least partly in the dielectric coating (29) and providing a photothermal examination result.

2. The manufacturing method according to claim 1, wherein the dielectric coating (29) has a relative permittivity greater than or equal to 2.

3. The manufacturing method according to claim 1 or 2, wherein the electrically conductive layer (31) substantially covers entirely the dielectric coating (29).

4. The manufacturing method according to any of claims 1 to 3, wherein the provision of the support (5) comprises a sub-step for depositing the electrically conductive layer (31) on at least one portion of the dielectric coating (29).

5. The manufacturing method according to claim 4, wherein the sub-step for depositing the electrically conductive layer (31) comprises a physical vapor phase deposition of the electrically conductive layer (31) on the dielectric coating (29).

6. The manufacturing method according to any of claims 1 to 5, wherein the electrically conductive layer (31) has a thickness comprised between 10 nanometers and 5 µm.

7. The manufacturing method according to any of claims 1 to 6, wherein the electric excitation step has a duration comprised between 0.01 and 10 seconds.

8. The manufacturing method according to any of claims 1 to 7, wherein, in the electric excitation step, the voltage source (33) is adapted for having a direct current i circulate through the support (5).

9. The manufacturing method according to any of claims 1 to 8, wherein the photothermal examination step comprises the taking, in the infrared domain of at least one image (45) of the excited support (5).

10. The manufacturing method according to claim 9, wherein the photothermal examination step comprises taking at least two time-shifted and/or spectrally-shifted images relatively to each other, or more than two time-shifted and/or spectrally-shifted images.

11. The manufacturing method according to any of claims 9 and 10, wherein the photothermal examination of the support comprises the measurement of the temperature variation of the excited support (5), the detection of a possible defect (49, 51) being carried out by determining an extremum of a representative quantity of a thermal gradient observed in the image (45).

12. The manufacturing method according to any of the preceding claims, wherein the layer (31) is formed by any or several arbitrary materials selected from among: Al, Ag, Au, Mo, Na, Cr, CeCu₆, CeSn₃, the alloys SiGe, Bi₂Te₃, PbTe, GeTe, the alloys MgSiSn, ZnO, TiO₂, Pt, RhFe, vanadium oxides, amorphous silicon and iron oxides.

13. The manufacturing method according to any of claims 1 to 12, wherein the optoelectronic module (100) is a photovoltaic cell.

14. The manufacturing method according to any of claims 1 to 13, wherein the additional layer (107) has optoelectronic properties.
